# EUROPÄISCHE PATENTANMELDUNG

(11) **EP 2 906 026 A1**
(43) Veröffentlichungstag der Anmeldung: **12.08.2015**
(21) Anmeldenummer: 15154017.6
(22) Anmeldetag: 05.02.2015
(51) Int. Cl.: H05K 3/22, H05K 3/12, H05K 3/34, H05K 1/02

(54) **Vorrichtung und Verfahren zum Bedrucken von Substraten**

(30) Priorität: 06.02.2014 DE 102014202170
(71) Anmelder: Ekra Automatisierungssysteme GmbH, 74357 Bönnigheim (DE)
(72) Erfinder: Vegelahn, Torsten, 75447 Sternenfels (DE)
(74) Vertreter: Clarenbach, Carl-Philipp

(57) **Zusammenfassung**

Die Erfindung betrifft eine Vorrichtung (1) zum Bedrucken von Substraten (4), insbesondere Leiterplatten, Solarzellen oder Folien, mit einem Druckmedium, insbesondere Lotpaste, gemäß einer vorgebbaren Struktur, wobei die Vorrichtung (1) mindestens eine Druckeinrichtung (2) aufweist, die das jeweilige Substrat gemäß der vorgebbaren Struktur mit dem Druckmedium bedruckt, und mindestens eine Inspektionseinrichtung (6), die die auf das jeweilige Substrat (4) aufgebrachte Struktur erfasst und mit der vorgebbaren Struktur vergleicht, um in der aufgebrachten Struktur fehlerhafte Abschnitte zu ermitteln, in denen Druckmedium fehlt, wobei die Inspektionseinrichtung (6) ein Substrat (4), bei dem ein fehlerhafter Abschnitt ermittelt wurde, einer Bearbeitungseinrichtung zuführt. Dabei ist vorgesehen, dass die Bearbeitungseinrichtung als Korrektureinrichtung ausgebildet ist, die mindestens einen Dispenser (9) aufweist, welcher den fehlerhaften Abschnitt durch gezieltes Zuführen von Druckmedium repariert.

## Beschreibung

Die Erfindung betrifft eine Vorrichtung gemäß Oberbegriff des Anspruchs 1 zum Bedrucken von Substraten, insbesondere Leiterplatten, Solarzellen oder Folien, mit einem Druckmedium, insbesondere Lotpaste, gemäß einer vorgebbaren Struktur, wobei die Vorrichtung mindestens eine Druckeinrichtung aufweist, die das jeweilige Substrat gemäß der vorgegebenen Struktur mit dem Druckmedium bedruckt, und mindestens eine Inspektionseinrichtung, die die auf das jeweilige Substrat aufgebrachte Struktur erfasst und mit der vorgegebenen Struktur vergleicht, um in der aufgebrachten Struktur fehlerhafte Abschnitte zu ermitteln, in denen Druckmedium fehlt, wobei die Inspektionseinrichtung ein Substrat, bei dem ein fehlerhafter Abschnitt ermittelt wurde, einer Bearbeitungseinrichtung zuführt.

Ferner betrifft die Erfindung ein Verfahren zum Betreiben einer derartigen Vorrichtung gemäß Oberbegriff des Anspruchs 8.

Vorrichtungen und Verfahren der eingangs genannten Art sind aus dem Stand der Technik bekannt. Moderne Druckmaschinen arbeiten in der Art einer Fertigungsstraße, wobei das zu bedruckende Druckgut beziehungsweise das Substrat über eine Zuführung zunächst in eine Druckeinrichtung gelangt. In der Druckeinrichtung wird das Substrat zweckmäßigerweise bezüglich einer Vorlage ausgerichtet und ein Druckmedium beispielsweise mittels einem oder mehreren Rakel auf zumindest einer Seite des Substrats aufgebracht. Anschließend wird das Substrat mittels einer Inspektionseinrichtung inspiziert, wobei die Inspektionseinrichtung in die Druckeinrichtung integriert oder separat dazu ausgebildet sein kann. Die Inspektionseinrichtung erfasst die auf das Substrat aufgebrachte Struktur üblicherweise durch optische Mittel und vergleicht die aufgebrachte Struktur mit der vorgebbaren beziehungsweise vorgegebenen Struktur. Ergibt der Vergleich, dass die aufgebrachte Struktur nicht der vorgegebenen Struktur entspricht, so wird auf Fehler in der aufgebrachten Struktur erkannt. Das entsprechend fehlerbehaftete Substrat wird einem Benutzer angezeigt oder wird automatisch der Drucklinie entnommen und einer Bearbeitungseinrichtung zugeführt. Üblicherweise handelt es sich bei der Bearbeitungseinrichtung um eine Wascheinrichtung, die die aufgebrachte Paste von dem Substrat rückstandslos entfernt. Bei Substraten, die bereits auf der anderen Seite mit Bauteilen versehen sind, ist das Durchführen eines derartigen Waschvorgangs jedoch nicht immer möglich oder erlaubt. In vielen Fällen ist ein Waschen des Substrats überhaupt nicht erlaubt und eine manuelle Nacharbeit ist nicht zulässig. Dies führt dazu, dass Substrate, deren Druckpastenstruktur fehlerbehaftet ist, als Schrottteile enden, was zu einer Erhöhung der Herstellungskosten führen kann.

Der Erfindung liegt somit die Aufgabe zugrunde, eine Vorrichtung zu schaffen, die die Anzahl der Schrottteile und damit die Gefahr hoher Herstellungskosten reduziert.

Die der Erfindung zugrunde liegende Aufgabe wird durch eine Vorrichtung mit den Merkmalen des Anspruchs 1 gelöst. Durch die erfindungsgemäße Vorrichtung wird das Ausbessern fehlerhafter Druckstrukturen ermöglicht, sodass die Anzahl der Schrottteile aufgrund fehlerhafter Druckstrukturen auf null heruntergefahren oder zumindest verringert wird. Der hierfür erforderliche Aufwand ist verhältnismäßig gering und führt auch zu keinen besonders hohen Zusatzkosten. Die Erfindung sieht vor, dass die Bearbeitungseinrichtung als Korrektureinrichtung ausgebildet ist, die mindestens einen Dispenser aufweist, welcher den fehlerhaften Abschnitt durch gezieltes Zuführen von Druckmedium repariert. Die Korrektureinrichtung weist also einen Dispenser auf, der mit Druckmedium versorgt wird und dieses gezielt auf das Substrat abgeben kann. Bevorzugt ist der Dispenser dazu mit einer Druckspitze versehen, die besonders bevorzugt verlagerbar angeordnet ist. Insbesondere ist die Druckspitze in einer Ebene parallel zu dem Substrat verlagerbar. Besonders bevorzugt ist vorgesehen, dass die Druckspitze außerdem in der Höhe verfahrbar ausgebildet/angeordnet ist. Hierdurch wird erreicht, dass Druckmedium an den Stellen des Substrats nachgeführt werden kann, an welchem zuvor Fehler erkannt wurden.

Gemäß einer vorteilhaften Weiterbildung der Erfindung ist vorgesehen, dass die Inspektionseinrichtung eine erste Kameraeinrichtung aufweist, mittels der sie Informationen bezüglich des jeweiligen fehlerhaften Abschnitts erfasst. Die Kameraeinrichtung erfasst insbesondere das Druckmuster beziehungsweise die gedruckte Struktur sowie dessen Ausrichtung in Bezug auf das Substrat. Zweckmäßigerweise sind die Substrate mit Orientierungsmarken (Fiducials) versehen, die von der Kameraeinrichtung zur Orientierung erfasst werden. Die Orientierungsmarken sind dabei auf den Substraten stets an der gleichen Stelle vorgesehen. Neben der Position des Fehlers beziehungsweise des fehlenden Abschnitts der Struktur erfasst die Kameraeinrichtung bevorzugt auch die Ausdehnung, also die Größe des Fehlers, wobei hier sowohl Breite und Länge des fehlenden Abschnitts als auch bevorzugt die Höhe des fehlenden Druckmediums in diesem Abschnitt erkannt werden. Die dadurch erfassten Informationen werden dann bevorzugt mittels einer Übermittlungseinrichtung an die Korrektureinrichtung weitergeleitet, sodass diese Informationen der Korrektureinrichtung zur Verfügung stehen. So kann beispielsweise durch Zuführen von zusätzlichem Druckmedium ein Abschnitt der Struktur, bei dem Druckmedium zum Erreichen der vorgegebenen Höhe fehlt, ausgebessert werden.

Bevorzugt weist die Korrektureinrichtung Mittel zum Ausrichten des jeweiligen Substrats und/oder des Dispensers auf. Bei den Mitteln handelt es sich insbesondere um einen oder mehrere Aktoren, die den Dispenser beziehungsweise die Druckspitze des Dispensers in die gewünschte Richtung verlagern. Alternativ oder zusätzlich können die Mittel zum Ausrichten des Substrats vorgesehen sein. Dadurch ist eine Grundausrichtung des Substrats in der Korrektureinrichtung möglich, die die spätere Bearbeitung mittels des Dispensers erleichtert. Alternativ ist es bevorzugt vorgesehen, dass die Ausrichtung des Substrats mittels der Orientierungsmarken erfasst wird und davon ausgehend das Koordinatensystem, in welchem der Dispenser arbeitet, an die Ausrichtung des Substrats angepasst wird.

Gemäß einer vorteilhaften Weiterbildung der Erfindung ist vorgesehen, dass die Mittel eine Einrichtung, insbesondere eine zweite Kameraeinrichtung zum Erfassen der Ausrichtung und/oder Position des jeweiligen Substrats bezüglich des Dispensers aufweisen. Wie die Inspektionseinrichtung weist also auch der Dispenser bevorzugt eine Kameraeinrichtung auf, mittels derer ein Ausrichten des jeweiligen Substrats in der Korrektureinrichtung durchgeführt wird, wobei zweckmäßigerweise zur Ausrichtung ebenfalls die bereits genannten Orientierungsmarken genutzt werden.

Gemäß einer bevorzugten Weiterbildung der Erfindung ist vorgesehen, dass die Korrektureinrichtung eine Recheneinheit aufweist, die in Abhängigkeit der mitgeteilten Informationen die Position und Menge des zuzuführenden Druckmediums bestimmt. Die Recheneinheit vergleicht die vorgegebene Druckstruktur mit dem Druckergebnis beziehungsweise den das Druckergebnis beschreibenden Informationen, um zu bestimmen, an welcher Stelle die Dispenseeinrichtung Druckmedium nach- beziehungsweise zuführen muss.

Besonders bevorzugt ist vorgesehen, dass der Dispenser als Schrauben- oder Spindeldispenser ausgebildet ist. Derartige Dispenser sind aus dem Stand der Technik grundsätzlich bekannt und für die Zuführung von Lotpaste als Druckmedium besonders geeignet. Da hierbei auf Standardteile zurückgegriffen werden kann, ist die Ausbildung der Korrektureinrichtung kostengünstig darstellbar.

Ferner ist bevorzugt vorgesehen, dass die Korrektureinrichtung mittels der zweiten Kameraeinrichtung oder mittels einer dritten Kameraeinrichtung das Ergebnis der Reparatur prüft. Bevor das durch die Korrektureinrichtung reparierte Substrat aus der Korrektureinrichtung herausgeführt wird, ist also vorgesehen, dass das Ergebnis der Korrektur geprüft wird. Erst wenn der fehlerhafte Abschnitt der Struktur auf dem Substrat ausreichend gut ausgebessert wurde, wird das Substrat aus der Korrektureinrichtung zur Endbearbeitung ausgeführt.

Das erfindungsgemäße Verfahren mit den Merkmalen des Anspruchs 8 zeichnet sich dadurch aus, dass als Bearbeitungseinrichtung eine Korrektureinrichtung vorgesehen wird, die einen Dispenser aufweist, wobei der fehlerhafte Abschnitt durch gezieltes Zuführen von Druckmedium mittels des Dispensers repariert wird. Es ergeben sich hierdurch die zuvor bereits genannten Vorteile. Weitere Vorteile und Ausführungsformen der Erfindung ergeben sich aus den Unteransprüchen sowie aus dem zuvor Beschriebenen. Zweckmäßigerweise wird das Verfahren von der zuvor genannten Recheneinheit ausgeführt.

Gemäß einer vorteilhaften Weiterbildung der Erfindung ist vorgesehen, dass die Korrektureinrichtung die Reparatur in Abhängigkeit von Informationen der Inspektionseinheit und von der vorgegebenen/vorgebbaren Struktur durchführt. Insbesondere ist vorgesehen, dass die Inspektionseinheit als Informationen die Position des erkannten Fehlers sowie dessen Ausdehnung (Größe/Höhe) erfasst. Weiterhin werden der Korrektureinrichtung die Daten der vorgegebenen Struktur mitgeteilt, sodass der entsprechende Vergleich mit der aufgebrachten Strukur erfolgen kann. Das Ausbessern/Reparieren beziehungsweise Zuführen von Druckmedium an dem fehlerhaften Abschnitt der Struktur erfolgt wie oben beschrieben.

Weiterhin ist bevorzugt vorgesehen, dass als Informationen eine Art des jeweiligen Substrats, eine Identifikation des jeweiligen Substrats, eine Position des jeweiligen fehlerbehafteten Abschnitts auf dem Substrat und/oder eine Art des fehlerhaften Abschnitts erfasst werden. Entsprechend lässt sich in der Korrektureinrichtung das Ausbessern der Struktur des Druckmediums optimieren.

Im Folgenden soll die Erfindung anhand eines Ausführungsbeispiels näher erläutert werden. Dazu zeigt die einzige
- Figur: eine Vorrichtung zum Bedrucken von Substraten in einer vereinfachten Darstellung.

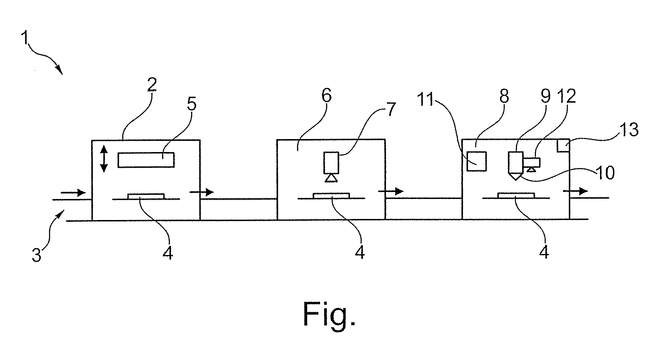

Die einzige Figur zeigt eine Vorrichtung 1 zum Bedrucken von Substraten, insbesondere von Leiterplatten, Keramikleiterplatten, Solarzellen, Folien oder dergleichen. Die Vorrichtung 1 weist drei Bearbeitungseinrichtungen auf, die in Reihe hintereinander angeordnet sind, sodass die Substrate nacheinander durch die einzelnen Bearbeitungseinrichtungen hindurchgeführt werden.

Die erste Bearbeitungseinrichtung ist als Druckeinrichtung 2 ausgebildet. Über eine Zuführung 3 wird der Druckvorrichtung 2 ein erstes Substrat 4 zugeführt, wie durch einen Pfeil angedeutet. Die Druckeinrichtung 2 weist weiterhin eine Druckmediumzufuhr sowie an einer Druckeinheit 5 eine sogenannte Vorlage, beispielsweise in Form einer Schablone, eines Siebs oder einer Maske, sowie ein Rakel auf, mittels dessen das Druckmedium durch die Vorlage hindurch auf das Substrat 4 aufgebracht wird. Die Druckeinheit 5 der Druckeinrichtung 2 kann dabei in der Höhe verfahren werden, um die Schablone nahe an das Substrat 4 heranführen zu können. Vor Durchführung des Druckvorgangs wird die Ausrichtung des Substrats 4 bezüglich der Vorlage mittels einer oder mehrerer Kameraeinrichtungen und einer entsprechenden Bildauswertung durchgeführt, sodass das Substrat beim Druckvorgang deckungsgleich zu der Vorlage ausgerichtet ist. Erst dann wird das Druckmedium mittels des Rakels durch die Vorlage hindurch auf das Substrat 4 aufgebracht.

Anschließend wird die Vorlage der Druckeinheit 5 wieder von dem Substrat 4 getrennt und das Substrat 4 aus der Druckeinrichtung 2 herausgeführt, wie durch einen Pfeil angedeutet. Das bedruckte Substrat 4 wird anschließend einer Inspektionseinrichtung 6 zugeführt. Gemäß einer alternativen Ausführungsform ist es auch denkbar, die Inspektionseinrichtung 6 in die Druckeinrichtung 2 integriert auszubilden. Die Inspektionseinrichtung 6 weist eine Kameraeinrichtung 7 auf, die die bedruckte Seite des Substrats 4 erfasst. Durch Bildauswertung wird die auf das Substrat 4 aufgebrachte Struktur des Druckmediums mit der durch die Vorlage vorgegebenen Struktur verglichen.

Die Substrate 4 weisen bevorzugt an ihrer zu bedruckenden Seite jeweils Orientierungsmarken auf, die sowohl in der Druckeinrichtung 2 als auch in der Inspektionseinrichtung 6 erfasst werden, um ein physisches Ausrichten des Substrats 4 oder ein virtuelles Ausrichten durchzuführen. Die Kameraeinrichtung 7 der Inspektionseinrichtung 6 erfasst zunächst die Orientierungsmarken des Substrats 4 und bringt diese mit den vorgegebenen Orientierungsmarken der Vorlage in Übereinstimmung. Anschließend wird die entsprechend ausgerichtete und von der Kameraeinrichtung 7 erfasste Struktur des Druckmediums mit der vorgegebenen Struktur der Druckvorlage verglichen. Wird bei dieser Überprüfung der Druckqualität ein Fehler erkannt, wird die Baugruppe beziehungsweise das jeweilige Substrat 4 elektronisch markiert. Dabei wird die Struktur vermessen und mit den Daten der Vorlage, den sogenannten Gerberdaten, die beispielsweise als CAD-Daten der Schablone, des Siebs oder der Baugruppe vorliegen, verglichen. Die erkannten Fehler werden insbesondere visualisiert und/oder gespeichert.

Als Fehler wird beispielsweise das Fehlen von Lotpaste erkannt. Dabei kann es sich um einen Abschnitt der Struktur handeln, in welchem die Lotpaste vollständig fehlt, oder zu gering aufgetragen wurde oder nur an einer Seite aufgetragen wurde. Die Inspektionseinrichtung 6 stellt einen Datensatz auf, der eine Baugruppen- beziehungsweise Substratnummer, die Position des Fehlers, ein Fehlerbild, Sollwerte (Vorlage) und gegebenenfalls das Bauteil umfasst, welches auf das Substrat 4 aufgebracht werden soll. Diese Informationen werden zusammen mit der Identifikation des Substrats 4, beispielsweise anhand der Baugruppennummer gespeichert. Zur besseren, sicheren Zuordnung der Baugruppen kann ein Datacode auf dem jeweiligen Substrat aufgebracht sein. Dieser eindeutige Code erlaubt die absolut sichere Zuordnung der erfassten Daten zu dem jeweiligen Substrat und wird bevorzugt mittels der jeweiligen Kameraeinrichtung ausgelesen.

Stellt sich bei der Inspektion heraus, dass die aufgebrachte Struktur der vorgegebenen Struktur entspricht, so wird das Substrat 4 der Endbearbeitung zugeführt. Wird jedoch erkannt, dass die aufgebrachte Struktur Fehler aufweist, so werden das Substrat 4 und die diesbezüglich gespeicherten Daten an die dritte Bearbeitungseinrichtung weitergeleitet, die als Korrektureinrichtung 8 ausgebildet ist.

Die Korrektureinrichtung 8 weist einen Dispenser 9 auf, der mit einer Druckspitze 10 versehen ist, durch welche Druckmedium gezielt auf das jeweilige Substrat 4 aufgebracht werden kann. Der Dispenser 9, insbesondere die Druckspitze 10 ist dabei sowohl in einer Ebene parallel zu dem Substrat 4 als auch in der Höhe verlagerbar.

Die Korrektureinrichtung 8 erhält die zuvor aufgestellten Informationen der Inspektionseinrichtung 6 sowie das Substrat 4. In der Korrektureinrichtung 8 wird das Substrat 4 zunächst fixiert und die Informationen werden ausgewertet. Die Korrektureinrichtung 8 nutzt, wie auch die Inspektionseinrichtung 6, die Daten der Vorlage als Grundlage und gegebenenfalls außerdem die Gerberdaten der Baugruppe und die Gerberdaten der Bauelemente, die auf das Substrat 4 aufgebracht werden sollen. Im Datensatz der Inspektionseinrichtung 6 werden insbesondere folgende Informationen gespeichert: Bauteil, Position des Bauteils, Pad-Nummer, erkannter Fehler an Position X/Y, Ausdehnung des fehlers (Fläche X/Y) und die Art des Fehlers. Die Korrektureinrichtung 8, insbesondere die Dispenseeinrichtung 9, nutzt zumindest diese Informationen und setzt sein Reparaturprogramm zum Ausbessern des erkannten Fehlers selbstständig zusammen. Hierzu weist die Korrektureinrichtung 8 eine Recheneinheit 13 auf.

Insbesondere erstellt die Korrektureinrichtung 8 ein baugruppenspezifisches beziehungsweise substratspezifisches Reparaturprogramm. Dabei verfährt sie in folgender Reihenfolge: Zunächst werden die Orientierungsmarken des Substrats 4 mittels einer Kameraeinrichtung 12 erfasst. Anschließend werden die zuvor genannten Informationen ausgelesen. Unter Zuhilfenahme dieser Informationen ermittelt die Korrektureinrichtung 8 die exakte Position der Fehler und den zum Ausbessern notwendigen Materialbedarf. Dabei werden die jeweiligen Gerberdaten zu den Orientierungsmarken in Deckung gebracht, und bevorzugt das Koordinatensystem der Dispenseeinrichtung 9 auf das Substrat 4 eingestellt (Nullpunkte).

Anschließend wird jeder Fehler beziehungsweise Defekt der aufgebrachten Druckstruktur im Einzelnen betrachtet. Die Daten der Vorlage geben die Sollgröße vor, die Informationen der Inspektionseinheit 6 enthalten den jeweiligen Ist-Wert sowie die Messvorgabe. Die Differenz aus Ist-Wert und Soll-Wert stellt den zu dispensierenden Materialbedarf dar. Die im Datensatz hinterlegte Fehlerposition stellt den Ort des Materialbedarfs dar. Die Korrektureinrichtung 8 berechnet die zu reparierende Fläche. Danach wird die gewünschte Höhe aus den Gerberdaten ausgelesen und mit den Daten der Bauelemente (Bestückinhalt) abgeglichen. So wird sichergestellt, dass die Mindesthöhe der Lotpaste beziehungsweise des Druckmediums für dieses Bauelement erreicht, aber die maximale Höhe nicht überschritten wird.

Stehen keine Informationen des Bestückinhalts zur Verfügung, so wird die zu dispensierende Menge anhand der Informationen der Inspektionseinrichtung 6 ermittelt. Dadurch wird die detektierte Lage und Fehlmenge (Fläche und Volumen) der Struktur zur Berechnung herangezogen. Diese Daten werden von der Inspektionseinrichtung 6 wie zuvor beschrieben übermittelt.

Mit den ermittelten Daten der Fläche und der Höhe wird nun ein Verfahr- und Dispenseprogramm erstellt. Dabei ist die Art des Dispensers zu berücksichtigen, da diese einen direkten Einfluss auf die Geschwindigkeit beziehungsweise Leistung des Druckvorgangs hat. Für Lotpasten als Druckmedium werden bevorzugt Schrauben- oder Spindeldispenser vorgesehen.

Die Berechnung muss die Fläche, die Höhe des aufzubringenden Materials, die Materialeigenschaften, wie beispielsweise die Viskosität, das Scherverhalten und die Geschwindigkeit des Dispensers 9 berücksichtigen. Diese Berechnung ist notwendig, um die richtige Menge des Druckmediums auf die korrekte Position des Substrats 4 aufbringen zu können. Es wird berechnet, welchen Weg der Dispenser 9 fahren muss und wie der Materialvorschub beziehungsweise die Dosiergeschwindigkeit, eingestellt werden müssen.

Hierdurch wird sichergestellt, dass beispielsweise bei nur teilweise be- oder gedruckten Pads beziehungsweise Kontaktflächen nur die fehlende Seite repariert und nicht wie üblich die zu dispensierende Menge mittig aufgebracht wird.

Vorzugsweise ist dem Dispenser 9 ein Sensor zugeordnet, der bevorzugt als Kameraeinrichtung ausgebildet ist und überprüft (inspiziert), ob das Druckmedium an der entsprechenden Stelle aufgebracht wurde. Sollte diese Inspektion nicht erfolgreich sein, so wird die Baugruppe beziehungsweise das Substrat 4 als defekt markiert und endgültig ausgefahren.

Nur wenn die Depothöhe gleichmäßig ist, kann das entsprechende Bauteil sicher bestückt und gelötet werden. Die Reparatur wird für jeden erfassten beziehungsweise erkannten Fehler des jeweiligen Substrats 4 durchgeführt, solange bis alle Fehler behoben wurden.

Die Vorrichtung 1 ermöglich somit eine vollautomatische Reparatur fehlerhafter Substrate, wobei Informationen der Inspektionseinrichtung 6 der Korrektureinrichtung 8 zur Verfügung gestellt werden, und wobei die Korrektureinrichtung 8 unter Verwendung der Daten der Vorlage, des Substrats und insbesondere einer Bauteilbibliothek ein Dienstprogramm erstellt, um die Fehlerstelle zu reparieren.

Bevorzugt weist die Korrektureinrichtung 8 eine Anzeigeeinrichtung 11 auf, an welcher einem Benutzer die erfassten Fehler angezeigt werden, sodass ein visueller Abgleich durch den Benutzer vorgenommen werden kann.

Mittels der Vorrichtung 1 werden der Ausschuss bei der Bedruckung von Substraten erheblich reduziert, Kosten gesenkt und die Qualität zu jeder Zeit gewährleistet, wobei ein hoher Produktionsfluss eingehalten werden kann.

## Patentansprüche

1. Vorrichtung (1) zum Bedrucken von Substraten (4), insbesondere Leiterplatten, Solarzellen oder Folien, mit einem Druckmedium, insbesondere Lotpaste, gemäß einer vorgebbaren Struktur, wobei die Vorrichtung (1) mindestens eine Druckeinrichtung (2) aufweist, die das jeweilige Substrat gemäß der vorgebbaren Struktur mit dem Druckmedium bedruckt, und mindestens eine Inspektionseinrichtung (6), die die auf das jeweilige Substrat (4) aufgebrachte Struktur erfasst und mit der vorgebbaren Struktur vergleicht, um in der aufgebrachten Struktur fehlerhafte Abschnitte zu ermitteln, in denen Druckmedium fehlt, wobei die Inspektionseinrichtung (6) ein Substrat (4), bei dem ein fehlerhafter Abschnitt ermittelt wurde, einer Bearbeitungseinrichtung zuführt, **dadurch gekennzeichnet, dass** die Bearbeitungseinrichtung als Korrektureinrichtung ausgebildet ist, die mindestens einen Dispenser (9) aufweist, welcher den fehlerhaften Abschnitt durch gezieltes Zuführen von Druckmedium repariert.

2. Vorrichtung nach Anspruch 1, **dadurch gekennzeichnet, dass** die Inspektionseinrichtung (6) eine erste Kameraeinrichtung (7) aufweist, mittels der sie Informationen bezüglich des jeweiligen fehlerhaften Abschnitts erfasst.

3. Vorrichtung nach einem der vorhergehenden Ansprüche, **dadurch gekennzeichnet, dass** die Korrektureinrichtung (8) Mittel zum Ausrichten des jeweiligen Substrats und/oder des Dispensers aufweist.

4. Vorrichtung nach einem der vorhergehenden Ansprüche, **dadurch gekennzeichnet, dass** die Mittel eine Einrichtung, insbesondere eine zweite Kameraeinrichtung (12), zum Erfassen der Ausrichtung und/oder Position des jeweiligen Substrats (4) bezüglich des Dispensers (9) aufweisen.

5. Vorrichtung nach einem der vorhergehenden Ansprüche, **dadurch gekennzeichnet, dass** die Korrektureinrichtung (8) eine Recheneinheit (13) aufweist, die in Abhängigkeit der durch die Inspektionseinrichtung (6) erfassten Informationen die Position und Menge des zuzuführenden Druckmediums bestimmt.

6. Vorrichtung nach einem der vorhergehenden Ansprüche, **dadurch gekennzeichnet, dass** der Dispenser (9) als Schrauben- oder Spindeldispenser ausgebildet ist.

7. Vorrichtung nach einem der vorhergehenden Ansprüche, **dadurch gekennzeichnet, dass** die Korrektureinrichtung (8) mittels der zweiten Kameraeinrichtung (12) oder mittels einer dritten Kameraeinrichtung das Ergebnis der Reparatur prüft.

8. Verfahren zum Betreiben einer Vorrichtung (1), insbesondere nach einem oder mehreren der vorhergehenden Ansprüche, zum Bedrucken von Substraten (4), insbesondere Leiterplatten, Solarzellen oder Folien, mit einem Druckmedium, insbesondere Lotpaste, gemäß einer vorgebbaren Struktur, wobei die Vorrichtung (1) mindestens eine Druckeinrichtung (2) aufweist, die das jeweilige Substrat gemäß der vorgebbaren Struktur mit dem Druckmedium bedruckt, und mindestens eine Inspektionseinrichtung (6), die die auf das jeweilige Substrat (4) aufgebrachte Struktur erfasst und mit der vorgebbaren Struktur vergleicht, um in der aufgebrachten Struktur fehlerhafte Abschnitte zu ermitteln, in denen Druckmedium fehlt, wobei ein Substrat (4), bei dem ein fehlerhafter Abschnitt ermittelt wurde, einer Bearbeitungseinrichtung zugeführt wird, **dadurch gekennzeichnet, dass** als Bearbeitungseinrichtung eine Korrektureinrichtung (8) vorgesehen wird, die mindestens einen Dispenser (9) aufweist, wobei der fehlerhafte Abschnitt durch gezieltes Zuführen von Druckmedium mittels des Dispensers (9) repariert wird.

9. Verfahren nach Anspruch 8, **dadurch gekennzeichnet, dass** die Korrektureinrichtung (8) die Reparatur in Abhängigkeit von Informationen der Inspektionseinheit (6) und von der vorgegebenen Struktur durchführt.

10. Verfahren nach Anspruch 8 oder 9, **dadurch gekennzeichnet, dass** als Informationen eine Art des jeweiligen Substrats (4), eine Identifikation des jeweiligen Substrats (4), eine Position des jeweiligen fehlerhaften Abschnitts auf dem Substrat (4) und/oder eine Art des fehlerhaften Abschnitts erfasst werden.
